# EUROPEAN PATENT SPECIFICATION

(11) **EP 1 350 266 B1**
(45) Date of publication and mention of the grant of the patent: **10.03.2010**
(21) Application number: 01989867.5
(22) Date of filing: 30.10.2001
(51) Int. Cl.: H01L 21/768

(54) **CONDUCTOR CHEMICAL-MECHANICAL POLISHING IN INTEGRATED CIRCUIT INTERCONNECTS**
LEITER-CHEMISCH-MECHANISCHES POLIEREN IN INTEGRIERTEN SCHALTUNGSVERBINDUNGSELEMENTEN
POLISSAGE CHIMICO-MECANIQUE DE CONDUCTEURS DANS L'INTERCONNEXION DE CIRCUITS INTEGRES

(30) Priority: 18.11.2000 US 716012; 18.11.2000 US 715670
(43) Date of publication of application: 08.10.2003
(73) Proprietor: GlobalFoundries, Inc., Grand Cayman KY1-1104 (KY)
(72) Inventor: YANG, Kai-Yueh, San Jose, CA 94513 (US); SAHOTA, Kashmir, S., Fremont, CA 94539 (US); AVANZINO, Steven, C., Cupertino, CA 95014 (US)
(74) Representative: Picker, Madeline Margaret
(86) International application number: PCT/US2001/046136
(87) International publication number: WO 2002/041392

(56) References cited:
- WO-A-00/25984
- US-A- 5 840 629
- US-A- 6 071 809
- US-A- 6 114 246

## Description

### TECHNICAL FIELD

The present invention relates generally to semiconductor technology and more specifically to chemical-mechanical polishing solutions and pads in semiconductor processing.

### BACKGROUND ART

In the manufacture of integrated circuits, after the individual devices such as the transistors have been fabricated in and on the semiconductor substrate, they must be connected together to perform the desired circuit functions. This interconnection process is generally called "metallization" and is performed using a number of different photolithographic, deposition, and removal techniques.

In one interconnection process, which is called a "dual damascene" technique, two channels of conductor materials are separated by interlayer dielectric layers in vertically separated planes perpendicular to each other and interconnected by a vertical connection, or "via", at their closest point. The dual damascene technique is performed over the individual devices which are in a device dielectric layer with the gate and source/drain contacts, extending up through the device dielectric layer to contact one or more channels in a first channel dielectric layer.

The first channel formation of the dual damascene process starts with the deposition of a thin first channel stop layer. The first channel stop layer is an etch stop layer which is subject to a photolithographic processing step which involves deposition, patterning, exposure, and development of a photoresist, and an anisotropic etching step through the patterned photoresist to provide openings to the device contacts. The photoresist is then stripped. A first channel dielectric layer is formed on the first channel stop layer. Where the first channel dielectric layer is of an oxide material, such as silicon oxide (SiO₂), the first channel stop layer is a nitride, such as silicon nitride (SiN), so the two layers can be selectively etched.

The first channel dielectric layer is then subject to further photolithographic process and etching steps to form first channel openings in the pattern of the first channels. The photoresist is then stripped.

An optional thin adhesion layer is deposited on the first channel dielectric layer and lines the first channel openings to ensure good adhesion of subsequently deposited material to the first channel dielectric layer. Adhesion layers for copper (Cu) conductor materials are composed of materials such as tantalum (Ta), titanium (Ti), tungsten (W), and their nitrides which are good barrier materials and have good adhesion to the dielectric materials.

Good barrier materials provide resistance to the diffusion of copper from the copper conductor materials to the dielectric material. High barrier resistance is necessary with conductor materials such as copper to prevent diffusion of subsequently deposited copper into the dielectric layer, which can cause short circuits in the integrated circuit.

However, these nitride compounds also have relatively poor adhesion to copper and relatively high electrical resistance.

Because of the drawbacks, pure refractory metals such as tantalum (Ta), titanium (Ti), or tungsten (W) are deposited on the adhesion layer to line the adhesion layer in the first channel openings. The refractory metals are good barrier materials, have lower electrical resistance than their nitrides, and have good adhesion to copper.

In some cases, the barrier material has sufficient adhesion to the dielectric material that the adhesion layer is not required, and in other cases, the adhesion and barrier material become integral. The adhesion and barrier layers are often collectively referred to as a "barrier" layer herein.

For conductor materials such as copper, which are deposited by electroplating, a seed layer is deposited on the barrier layer and lines the barrier layer in the first channel openings. The seed layer, generally of copper, is deposited to act as an electrode for the electroplating process.

A first conductor material is deposited on the seed layer and fills the first channel opening. The first conductor material and the seed layer generally become integral, and are often collectively referred to as the conductor core when discussing the main current-carrying portion of the channels.

A chemical-mechanical polishing (CMP) process is then used to remove the first conductor material, the seed layer, and the barrier layer above the first channel dielectric layer to form the first channels. When a layer is placed over the first channels as a final layer, it is called a "capping" layer and the "single" damascene process is completed. When additional layers of material are to be deposited for the dual damascene process, the capping layer also functions as an etch stop layer for a via formation step.

The via formation step of the dual damascene process continues with the deposition of a via dielectric layer over the first channels, the first channel dielectric layer, and the capping or via stop layer. The via stop layer is an etch stop layer which is subject to photolithographic processing and anisotropic etching steps to provide openings to the first channels. The photoresist is then stripped.

A via dielectric layer is formed on the via stop layer. Again, where the via dielectric layer is of an oxide material, such as silicon oxide, the via stop layer is a nitride, such as silicon nitride, so the two layers can be selectively etched. The via dielectric layer is then subject to further photolithographic process and etching steps to form the pattern of the vias. The photoresist is then stripped.

A second channel dielectric layer is formed on the via dielectric layer. Again, where the second channel dielectric layer is of an oxide material, such as silicon oxide, the via stop layer is a nitride, such as silicon nitride, so the two layers can be selectively etched. The second channel dielectric layer is then subject to further photolithographic process and etching steps to simultaneously form second channel and via openings in the pattern of the second channels and the vias. The photoresist is then stripped.

An optional thin adhesion layer is deposited on the second channel dielectric layer and lines the second channel and the via openings.

A barrier layer is then deposited on the adhesion layer and lines the adhesion layer in the second channel openings and the vias.

Again, for conductor materials such as copper and copper alloys, which are deposited by electroplating, a seed layer is deposited by electro-less deposition on the barrier layer and lines the barrier layer in the second channel openings and the vias.

A second conductor material is deposited on the seed layer and fills the second channel openings and the vias.

A CMP process is then used to remove the second conductor material, the seed layer, and the barrier layer above the second channel dielectric layer to simultaneously form the vias and the second channels. When a layer is placed over the second channels as a final layer, it is called a "capping" layer and the "dual" damascene process is completed.

Individual and multiple levels of single and dual damascene structures can be formed for single and multiple levels of channels and vias, which are collectively referred to as "interconnects".

The use of the single and dual damascene techniques eliminates metal etch and dielectric gap fill steps typically used in the metallization process. The elimination of metal etch steps is important as the semiconductor industry moves from aluminum (Al) to other metallization materials, such as copper, which are very difficult to etch.

One of the major problems encountered during the CMP process is that the various solutions used to provide the chemical portion of the process do not have high selectivity from the conductor material, such as copper (Cu) to the barrier materials, such as tantalum (Ta) or tantalum nitride (TaN). The current selectivity is in the range of 10:1 to 50:1 selectivity of copper to tantalum or tantalum nitride.

As a result of the lack of high selectivity to the barrier material, the conductor and the barrier layers are easily polished away together and both the channels and dielectric layers are subject to "erosion", or undesirable CMP of the channel and dielectric materials, which makes it difficult to control the channel thickness.

Also, because of the lack of high selectivity to the barrier material, when the barrier layer is polished away, the channels alone are subject to "dishing", or undesirable CMP of the conductor material, which also makes it difficult to control the channel thickness.

One problematic answer to this problem has been to provide very thick barrier layers, which provide large process margins during CMP. Unfortunately, these materials have relatively high resistance and tend to reduce the overall current-carrying capability of the channels.

Solutions to these problems have been long sought but have long eluded those skilled in the art.

### DISCLOSURE OF THE INVENTION

In one embodiment, the present invention provides a method of manufacturing an integrated circuit comprising: providing a semiconductor substrate having a semiconductor device provided thereon; forming a dielectric layer on the semiconductor substrate; forming an opening in the dielectric layer; depositing a barrier layer to line the opening; depositing a conductor core over the barrier layer to fill the opening and connect to the semiconductor device; and chemical-mechanical polishing the conductor core; characterized in that the chemical-mechanical polishing uses an abrasiveless solution comprising deionised water containing the following: oxalic acid from 0.1% to 2.0%, benzotriazole from 0.05% to 0.4%, 30% peroxide solution from 3% to 15% by weight, and Triton X-100 from 50 parts per million (ppm) to 100 ppm.

In another embodiment, the present invention provides use of, in combination, an abrasiveless solution and an abrasive pad in performing chemical mechanical polishing of a conductor core selectively to a barrier layer in a damascene process during manufacture of an integrated circuit, the combination comprising: the abrasiveless solution including deionized water containing the following: oxalic acid from 0.1% to 2.0%, benzotriazole from 0.05% to 0.4%, 30% peroxide solution from 3% to 15% by weight, and Triton X-100 from 50 parts per million (ppm) to 100 ppm; and the abrasive pad; the combination resulting in about a 200:1 selectivity from a conductor core of the integrated circuit to a barrier layer of the integrated circuit when the conductor core is copper and the barrier layer is tantalum nitride.

In yet another embodiment, the present invention provides use of in combination, an abrasiveless solution and a grooved pad in performing chemical mechanical polishing of a conductor cove selectively to a barrier layer in a damascene process. during manufacture of an integrated circuit, the combination comprising: the abrasiveless solution including deionized water containing the following: oxalic acid from 0.1% to 2.0%, benzotriazole from 0.05% to 0.4%, 30% peroxide solution from 3% to 15% by weight, and Triton, X-100 from 50 parts per million (ppm) to 100 ppm; and the grooved pad; the combination resulting in about a 300:1 selectivity from a conductor core of the integrated circuit to a barrier layer of the integrated circuit when the conductor core is copper and the barrier layer (226) is tantalum nitride.

### BRIEF DESCRIPTION OF THE DRAWINGS

FIG. 1 (PRIOR ART) is a plan view of aligned channels with a connecting via,
FIG. 2 (PRIOR ART) is a cross-section of FIG. 1 along line 2-2;
FIG. 3 is a cross-section similar to FIG. 2 (PRIOR ART) showing the reduced barrier layer thickness of the present invention;
FIG. 4 (PRIOR ART) shows a step in the chemical-mechanical polishing process and depicts the channel erosion and dishing;
FIG. 5 shows a step in one mode of the chemical-mechanical polishing process of the present invention; and
FIG. 6 shows a step in another mode of the chemical mechanical polishing process of the present invention.

### BEST MODE FOR CARRYING OUT THE INVENTION

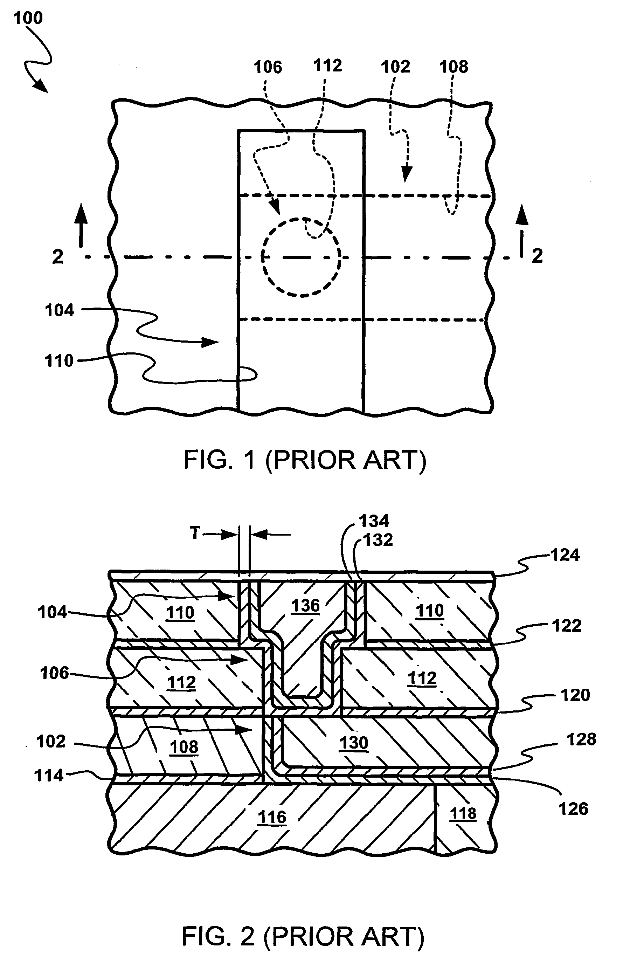

Referring now to FIG. 1 (PRIOR. ART), therein is shown a plan view of a - semiconductor wafer 100 having as interconnects first and second channels 102 and 104 connected by a via 106. The first and second channels 102 and 104 are respectively disposed in first and second dielectric layers 108 and 110. The via 106 is an integral part of the second channel 104 and is disposed in a via dielectric layer 112.

The term "horizontal" as used herein is defined as a plane parallel to the conventional plane or surface of a wafer, such as the semiconductor wafer 100, regardless of the orientation of the wafer. The term "vertical" refers to a direction perpendicular to the horizontal as just defined and the thickness of the channels and dielectric layers are measured in the vertical direction. Terms, such as "on", "above", "below", "side" (as in "sidewall"), "higher", "lower", "over", and "under", are defined with respect to the horizontal plane.

Referring now to FIG. 2 (PRIOR ART), therein is shown a cross-section of FIG. 1 (PRIOR ART) along line 2-2. A portion of the first channel 102 is disposed in a first channel stop layer 114 and is on a device dielectric layer 116. Generally, metal contacts are formed in the device dielectric layer 116 to connect to an operative semiconductor device (not shown). This is represented by the contact of the first channel 102 with a semiconductor contact 118 embedded in the device dielectric layer 116. The various layers above the device dielectric layer 116 are sequentially: the first channel stop layer 114, the first channel dielectric layer 108, a via stop layer 120, the via dielectric layer 112, a second channel stop layer 122, the second channel dielectric layer 110, and a next channel stop layer 124 (not shown in FIG. 1).

The first channel 102 includes a barrier layer 126, which could optionally be a combined adhesion and barrier layer, and a seed layer 128 around a conductor core 130. The second channel 104 and the via 106 include a barrier layer 132, which could also optionally be a combined adhesion and barrier layer, and a seed layer 134 around a conductor core 136. The barrier layers 126 and 132 are used to prevent diffusion of the conductor materials into the adjacent areas of the semiconductor device. As shown, conventional barrier layers 126 and 132 have a thickness "T" since they are used as a chemical-mechanical polishing (CMP) stop for the CMP of the conductor cores 130 and 136. The thickness "T" is required because it is difficult to stop at the conductor core to barrier layer interface and it is expected that some of the barrier layer will be eroded before the CMP process is able to stop.

The seed layers 128 and 134 form electrodes on which the conductor material of the conductor cores 130 and 136 are deposited. The seed layers 128 and 134 are of substantially the same conductor material as the conductor cores 130 and 136 and become part of the respective conductor cores 130 and 136 after the deposition.

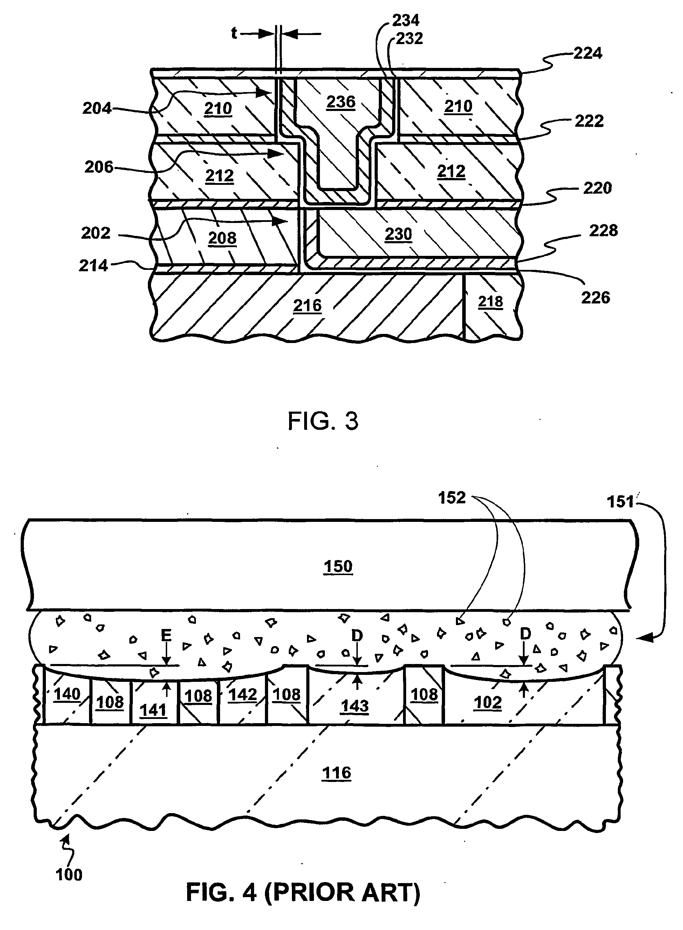

Referring now to FIG. 3, therein is shown a cross-section similar to that shown in FIG. 2 (PRIOR ART) of a semiconductor wafer 200 of the present invention. The semiconductor wafer 200 has first and second channels 202 and 204 connected by a via 206. The first and second channels 202 and 204 are respectively disposed in first and second dielectric layers 208 and 210. The via 206 is a part of the second channel 204 and is disposed in a via dielectric layer 212.

A portion of the first channel 202 is disposed in a first channel stop layer 214 and is on a device dielectric layer 216. Generally, metal contacts (not shown) are formed in the device dielectric layer 216 to connect to an operative semiconductor device (not shown). This is represented by the contact of the first channel 202 with a semiconductor contact 218 embedded in the device dielectric layer 216. The various layers above the device dielectric layer 216 are sequentially: the first channel stop layer 214, the first channel dielectric layer 208, a via stop layer 220, the via dielectric layer 212, a second channel stop layer 222, the second channel dielectric layer 210, and a next channel stop layer 224.

The first channel 202 includes a barrier layer 226 and a seed layer 228 around a conductor core 230. The second channel 204 and the via 206 include a barrier layer 232 and a seed layer 234 around a conductor core 236. The barrier layers 226 and 232 are used to prevent diffusion of the conductor materials into the adjacent areas of the semiconductor device. As shown, the barrier layers 226 and 232 have a thickness "t" which is substantially less than the comparable thickness "T" of the conventional barrier layers 126 and 132 of FIG. 2. In the one embodiment of the present invention, the thickness "t" of the barrier layer is less than 8% of the height of the dielectric layer (and the channel opening) and has a thickness of less than 350 Å (1 Å = 0.1 nm). This reduced thickness is possible because of the high selectivity of the chemical portion of the CMP solution as will later be explained. At the same time, the conductor core and barrier layer have a combined thickness less than the thickness of the dielectric layer containing them due to the minimization of the erosion and dishing as will also later be explained.

The seed layers 228 and 234 form electrodes on which the conductor material of the conductor cores 230 and 236 are deposited. The seed layers 228 and 234 are of substantially the same conductor material as the conductor cores 230 and 236 and become part of the respective conductor cores 230 and 236 after the deposition.

The barrier layers are of materials such as tantalum (Ta), titanium (Ti), tungsten (W), nitrides thereof, and a combination thereof. The seed layers and conductor cores are of materials such as copper (Cu), copper-base alloys, aluminum (Al), aluminum-base alloys, gold (Au), gold-base alloys, silver (Ag), silver-base alloys, and a combination thereof.

Referring now to FIG. 4 (PRIOR ART), therein is shown a step in the CMP process in which a first channel surface of the semiconductor wafer 100 is planarized. Therein is thus shown the planarization of the first channel 102, other channels 140 through 143, and the first channel dielectric layer 108. A flat polishing pad 150 is used with a conventional CMP slurry 151 containing abrasive particles 152. There are a number of different slurries known which consist of sized abrasive particles carried by a CMP solution.

Since the chemical selectivity of the CMP solutions is relatively low, for example for copper to tantalum nitride, they are in the range of 20 to 1, it is necessary to have a relatively thick "T" for the barrier layer 126 shown in FIG. 2 (PRIOR ART). If the barrier layer 126 is too thin, the abrasive will abrade through the barrier layer 126 and the CMP solution will remove both the conductor material, such as copper, as well as the dielectric material, such as silicon oxide, and cause the erosion "E". As seen in FIG. 4 (PRIOR ART), erosion "E" is the formation of a concave depression in the channels 140 through 142 and the first channel dielectric layer 108. Also as seen in FIG. 4 (PRIOR ART), dishing "D" is the formation of concave depressions in the wider or longer channel 143 and the first channel 102, which is also due to the low chemical selectivity. Both erosion and dishing can dramatically change the thickness of the channels and reduce their current-carrying capability.

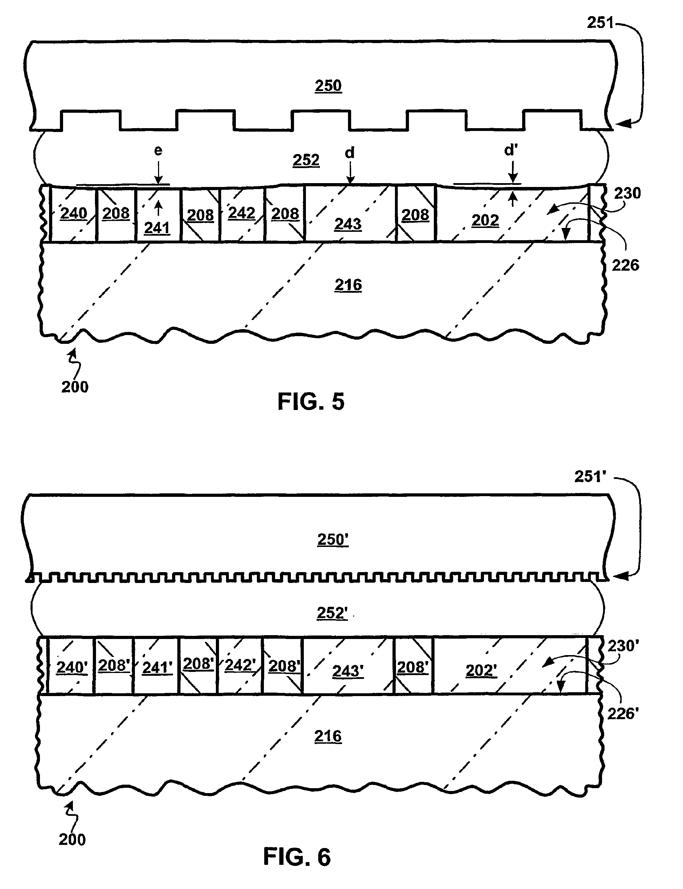

Referring now to FIG. 5, therein is shown the CMP step of one mode of the present invention in which a first channel surface of the semiconductor wafer 200 is planarized. Therein is thus shown the planarization of the first channel 202, other channels 240 through 243, and the first channel dielectric layer 208. A polishing pad 250 is used which contains grooves 251. A grooved polishing pad of polyurethane used in the present invention is obtainable from Rodel Inc. of Delaware.

An abrasiveless CMP solution 252 is used in the present invention comprised of deionized water containing the following: oxalic acid from 0.1% to 2.0%, benzotriazole from 0.05% to 0.4%, 30% peroxide solution from 3% to 15% by weight, and Triton, X-100 from 50 parts per million (ppm) to 100 ppm.

The Triton X-100 is manufactured by Union Carbide but is now well known in the art and is generally available from a number of manufacturers.

Since the chemical selectivity of the abrasiveless CMP solution 252 is found to be very high, for example for copper to tantalum nitride, it is in the range of 300 to 1, it is possible to have a thin "t" or the barrier layer 226 shown in FIG. 3. Even if the barrier layer 226 is too thin, the abrasiveless CMP solution 252 will only remove a very small amount of the conductor material, such as copper, as well as the dielectric material, such as silicon oxide, and cause the erosion "e". As seen in FIG. 5, erosion "e" is the formation of a very shallow concave depression, which is much less than the erosion "E", in the channels 240 through 242 and the first channel dielectric layer 208. Also as seen in FIG. 5, dishing "d" is the formation of a negligible concave depression in the wider or longer channel 243, which is much less than the dishing "D", and the formation of a very shallow concave depression (d') in the first channel 202, which is also due to the low chemical selectivity. Both erosion and dishing are dramatically reduced by the present invention and the thickness of the channels and their current-carrying capability are maintained.

It has also been found that the grooves 251 assist in in-situ conditioning which improves the CMP process.

As would be evident, each subsequent level of channels will be subject to the above process to form the integrated circuit interconnects.

Referring now to FIG. 6, therein is shown the CMP step of the present invention in which a first channel surface of the semiconductor wafer 200 is planarized. The structure of FIG. 3 is formed to the extent that the first channel dielectric layer 208' has been coated with the barrier material and the conductor material to the desired thicknesses to fill the channel openings in the first channel dielectric layer. Thus, therein is shown the planarization of the conductor material down to the barrier material over the first channel 202', other channels 240' through 243', and the first channel dielectric layer 208'. A polishing pad 250' is used which is coated with a fixed abrasive 251'. An adhesive coated polishing pad of polyurethane used in the present invention is obtainable from the 3M Corporation.

An abrasiveless CMP solution 252' is used in the present invention and is comprised of deionized water containing the following: oxalic acid from 0.1% to 2.0%, benzotriazole from 0.05% to 6.4%, 30% peroxide solution from 3% to 15% by weight, and Triton, X-100 from 50 parts per million (ppm) to 100 ppm.

Since the chemical selectivity of the abrasiveless CMP solution 252' is found to be very high, for example for copper to tantalum nitride, it is in the range of 200 to 1, it is possible to have a thin "t" for the barrier layer 226 shown in FIG. 3. In the present mode, the barrier layer is referred to as barrier layer 226'. Even if the barrier layer 226' is too thin, the abrasiveless CMP solution 252' will greatly slow down the removal of barrier material upon removing the copper material above it. When the barrier layer 226' is not removed, there will be no erosion in the channels 240' through 242' and the first channel dielectric layer 208'. Also as seen in FIG. 6, there will be no dishing in the wider or longer channel 243' or in the first channel 202'. Both erosion and dishing are eliminated by the present invention and the thickness of the channels and their current-carrying capability are maintained.

As would be evident, each subsequent level of channels will be subject to the above process to form the integrated circuit interconnects.

It has been found that the fixed abrasive polish pad 250' with a fixed alumina abrasive 251' (available from 3M Company) assists in in-situ conditioning which improves the CMP process.

Because of the high selectivity, a very thin barrier layer 226' having a thickness "t" may be used since the CMP of the conductor material outside the channel opening will stop once the barrier layer 226' is reached. Thus, there will be no erosion or dishing.

Subsequently, the barrier layer 226' is removed by using a reactive ion etching (RIE) process or a conventional barrier CMP process using silica or alumina slurry with a politex (manufactured by Rodel Inc.) or polyurethane polish pad. These processes will not cause erosion or dishing while removing the barrier layer 226'.

As would be evident, each subsequent channel will be subject to the above process to form the integrated circuit interconnects.

In the best mode, the barrier layers are of materials such as tantalum (Ta), titanium (Ti), tungsten (W), nitrides thereof, and a combination thereof. The seed layers and conductor cores are of materials such as copper (Cu), copper-base alloys, aluminum (AI), aluminum-base alloys, gold (Au), gold-base alloys, silver (Ag), silver-base alloys, and a combination thereof The dielectric layers are of silicon dioxide or a low dielectric material such as HSQ, Flare, etc. The stop layers are of materials such as silicon nitride or silicon oxynitride.

While the invention has been described in conjunction with a specific best mode, it is to be understood that many alternatives, modifications, and variations will be apparent to those skilled in the art in light of the aforegoing description. Accordingly, it is intended to embrace all such alternatives, modifications, and variations that fall within the included claims. All matters hitherto-fore set forth or shown in the accompanying drawings are to be interpreted in an illustrative and nonlimiting sense.

## Claims

1. A method of manufacturing an integrated circuit comprising:
providing a semiconductor substrate having a semiconductor device provided thereon;
forming a dielectric layer (208; 208', 216) on the semiconductor substrate;
forming an opening in the dielectric layer (208; 208', 216);
depositing a barrier layer (226; 226') to line the opening;
depositing a conductor core (230; 230') over the barrier layer (226; 226') to fill the opening and connect to the semiconductor device; and
chemical-mechanical polishing the conductor core (230; 230');
**characterized in that** the chemical-mechanical polishing uses an abrasiveless solution (252; 252') comprising deionised water containing the following: oxalic acid from 0.1% to 2.0%, benzotriazole from 0.05% to 0.4%, 30% peroxide solution from 3% to 15% by weight, and TritonX-100 from 50 parts per million (ppm) to 100 ppm.

2. A method of manufacturing an integrated circuit as claimed in claim 1, wherein the chemical-mechanical polishing uses a fixed abrasive pad (251').

3. A method of manufacturing an integrated circuit as claimed in claim 2, wherein the chemical-mechanical polishing results in about a 200:1 selectivity from the conductor core (230') to the barrier layer (226') when the conductor core (230') is copper and the barrier layer (226') is tantalum nitride.

4. A method of manufacturing an integrated circuit as claimed in claim 1, wherein the chemical-mechanical polishing uses a grooved pad (251).

5. A method of manufacturing an integrated circuit as claimed in claim 4, wherein the chemical-mechanical polishing results in about a 300:1 selectivity from the conductor core (230) to the barrier layer (226) when the conductor core (230) is copper and the barrier layer (226) is tantalum nitride.

6. A method of manufacturing an integrated circuit as claimed in anv one of claims 1 to 5, further comprising removing the barrier layer (226, 226') after chemical-mechanical polishing of the conductor core (230, 230').

7. Use of, in combination, an abrasiveless solution (252') and an abrasive pad (251') in performing chemical mechanical polishing of a conductor core selectively to a barrier layer in a damascene process during manufacture of an integrated circuit, the combination comprising:
the abrasiveless solution (252') including deionized water containing the following: oxalic acid from 0.1% to 2.0%, benzotriazole from 0.05% to 0.4%, 30% peroxide solution from 3% to 15% by weight, and Triton X-100 from 50 parts per million (ppm) to 100 ppm; and
the abrasive pad (251');
the combination resulting in about a 200:1 selectivity from a conductor core (230') of the integrated circuit to a barrier layer (226') of the integrated circuit when the conductor core (230') is copper and the barrier layer (226') is tantalum nitride.

8. Use of, in combination, an abrasiveless solution (252) and a grooved pad (251) in performing chemical mechanical polishing of a conductor core selectively to a barrier layer in a damascene process during manufacture of an integrated circuit, the combination comprising:
the abrasiveless solution (252) including deionized water containing the following: oxalic acid from 0.1% to 2.0%, benzotriazole from 0.05% to 0.4%, 30% peroxide solution from 3% to 15% by weight, and Triton, X-100 from 50 parts per million (ppm) to 100 ppm; and
the grooved pad (251);
the combination resulting in about a 300:1 selectivity from a conductor core (230) of the integrated circuit to a barrier layer (226) of the integrated circuit when the conductor core (230) is copper and the barrier layer (226) is tantalum nitride.

## Patentansprüche

1. Verfahren zur Herstellung einer integrierten Schaltung mit:
Bereitstellen eines Halbleitersubstrats, auf welchem ein Halbleiterbauelement vorgesehen ist;
Bilden einer dielektrischen Schicht (208, 208', 216) auf dem Halbleitersubstrat;
Bilden einer Öffnung in der dielektrischen Schicht (208, 208', 216);
Abscheiden einer Barrierenschicht (226, 226'), um die Öffnung auszukleiden;
Abscheiden eines Leiterkerns (230, 230') über der Barrierenschicht (226, 226'), um die Öffnung zu Füllen und um eine Verbindung zu dem Halbleiterbauelement herzustellen; und
chemisch-mechanisches Polieren des Leiterkerns (230, 230');
**dadurch gekennzeichnet, dass** das chemisch-mechanische Polieren unter Anwendung einer schleifteilchenfreien Lösung (252, 252') erfolgt, die deionisiertes Wasser mit dem folgenden Inhalt aufweist: Oxalsäure von 0,1% bis 2,0%, Benzotriazol von 0,05% bis 0,4%, 30%ige Peroxidlösung von 3% bis 15% in Gewichtsanteilen und Triton X-100 von 50 Teilen pro Million (ppm) bis 100 ppm.

2. Verfahren zur Herstellung einer integrierten Schaltung nach Anspruch 1, wobei das chemisch-mechanische Polieren unter Anwendung eines Schleifkissens mit fixierten Schleifteilchen (251') erfolgt.

3. Verfahren zur Herstellung einer integrierten Schaltung nach Anspruch 2, wobei das chemisch-mechanische Polieren eine Selektivität von ungefähr 200:1 zwischen dem Leiterkern (230') und der Barrierenschicht (226') aufweist, wenn der Leiterkern (230') Kupfer ist und wenn die Barrierenschicht (226') Tantalnitrid ist.

4. Verfahren zur Herstellung einer integrierten Schaltung nach Anspruch 1, wobei das chemisch-mechanische Polieren unter Anwendung eines Schleifkissens mit Rillen (251) erfolgt.

5. Verfahren zur Herstellung einer integrierten Schaltung nach Anspruch 4, wobei das chemisch-mechanische Polieren zu einer Selektivität von ungefähr 300:1 zwischen dem Leiterkern (230) und der Barrierenschicht (226) führt, wenn der Leiterkern (230) Kupfer ist und wenn die Barrierenschicht (226) Tantalnitrid ist.

6. Verfahren zur Herstellung einer integrierten Schaltung nach einem der Ansprüche 1 bis 5, das ferner umfasst: Entfernen der Barrierenschicht (226, 226') nach dem chemisch-mechanischen Polieren des Leiterkerns (230, 230').

7. Anwenden, in Kombination, einer schleifteilchenfreien Lösung (252') und eines Schleifkissens mit Schleifteilchen (251') beim Ausführen eines chemisch-mechanischen Polierens eines Leiterkerns selektiv zu einer Barrierenschicht in einem Damaszener-Prozess während der Herstellung einer integrierten Schaltung, wobei die Kombination umfasst:
die schleifteilchenfreie Lösung (252') deionisiertes Wasser mit dem folgenden Inhalt enthält: Oxalsäure von 0,1% bis 2,0%, Benzotriazol von 0,05% bis 0,4%, 30%ige Peroxidlösung mit 3% bis 15% Gewichtsanteilen und Triton X-100 von 50 Teilen pro Million (ppm) bis 100 ppm; und
das Schleifkissen mit Schleifteilchen (251');
wobei die Kombination zu einer Selektivität von ungefähr 200:1 zwischen dem Leiterkern (230') der integrierten Schaltung und der Barrierenschicht (226') der integrierten Schaltung führt, wenn der Leiterkern (230') Kupfer ist und die Barrierenschicht (226') Tantalnitrid ist.

8. Verwendung, in Kombination, einer schleifteilchenfreien Lösung (252) und eines Schleifkissens mit Rillen (251) beim Ausführen eines chemisch-mechanischen Polierens eines Leiterkerns selektiv zu einer Barrierenschicht in einem Damaszener-Prozess während der Herstellung einer integrierten Schaltung, wobei die Kombination umfasst:
die schleifteilchenfreie Lösung (252), die deionisiertes Wasser mit dem folgenden Inhalt enthält: Oxalsäure von 0,1% bis 2,0%, Benzotriazol von 0,05% bis 0,4%, 30% Peroxidlösung von 3% bis 15% Gewichtsanteilen und Triton X-100 von 50 Teilen pro Million (ppm) bis 100 ppm; und
das Schleifkissen mit Rillen (251);
wobei die Kombination zu einer Selektivität von ungefähr 300:1 zwischen dem Leiterkern (230) der integrierten Schaltung und der Barrierenschicht (226) der integrierten Schaltung führt, wenn der Leiterkern (230) Kupfer ist und wenn die Barrierenschicht (226) Tantalnitrid ist.

## Revendications

1. Procédé de fabrication d'un circuit intégré comprenant les étapes consistant à :
fournir un substrat semi-conducteur comportant, prévu sur lui, un dispositif à semi-conducteur,
former une couche de diélectrique (208 ; 208', 216) sur le substrat semi-conducteur ;
former une ouverture dans la couche de diélectrique (208 ; 208', 216) ;
déposer une couche barrière (226 ; 226') afin de gainer l'ouverture ;
déposer un coeur conducteur (230 ; 230') sur la couche barrière (226 ; 226') afin de remplir l'ouverture et de le connecter au dispositif à semi-conducteur ; et
effectuer un polissage chimico-mécanique du coeur conducteur (230 ; 230') ;
**caractérisé en ce que** le polissage chimico-mécanique utilise une solution sans abrasif (252 ; 252') comprenant de l'eau désionisée contenant ce qui suit : de 0,1 % à 2,0 % d'acide oxalique, de 0,05% à 0,4% de benzotriazole, de 3% à 15% en poids d'une solution de peroxyde à 30%, et de 50 parties par million (ppm) à 100 ppm de Triton X-100.

2. Procédé de fabrication d'un circuit intégré selon la revendication 1, dans lequel le polissage chimico-mécanique utilise un tampon abrasif fixe (251').

3. Procédé de fabrication d'un circuit intégré selon la revendication 2, dans lequel le polissage chimico-mécanique aboutit à une sélectivité de 200:1 environ du coeur conducteur (230') à la couche barrière (226') lorsque le coeur conducteur (230') est en cuivre et que la couche barrière (226') est en nitrure de tantale.

4. Procédé de fabrication d'un circuit intégré selon la revendication 1, dans lequel le polissage chimico-mécanique utilise un tampon à rainures (251).

5. Procédé de fabrication d'un circuit intégré selon la revendication 4, dans lequel le polissage chimico-mécanique aboutit à une sélectivité de 300:1 environ du coeur conducteur (230) à la couche barrière (226) lorsque le coeur conducteur (230) est en cuivre et que la couche barrière (226) est en nitrure de tantale.

6. Procédé de fabrication d'un circuit intégré selon l'une quelconque des revendications 1 à 5, consistant, de plus, à éliminer la couche barrière (226, 226') après le polissage chimico-mécanique du coeur conducteur (230, 230').

7. Utilisation, en combinaison, d'une solution sans abrasif (252')et d'un tampon abrasif (251') dans la réalisation d'un polissage chimico-mécanique d'un coeur conducteur de façon sélective par rapport à une couche barrière dans un processus damascène pendant la fabrication d'un circuit intégré, la combinaison, comprenant :
la solution dépourvue d'abrasif (252') comportant de l'eau désionisée contenant ce qui suit : de 0,1% à 2,0% d'acide oxalique, de 0,05% à 0,4% de benzotriazole, de 3% à 15% en poids d'une solution de peroxyde à 30% et de 50 parties par million (ppm) à 100 ppm de Triton X-100 ; et
le tampon abrasif (251') ;
la combinaison aboutissant à une sélectivité de 200:1 environ du coeur conducteur (230') du circuit intégré à une couche barrière (226') du circuit intégré lorsque le coeur conducteur (230') est en cuivre et que la couche barrière (226') est en nitrure de tantale.

8. Utilisation, en combinaison, d'une solution dépourvue d'abrasif (252) et d'un tampon à rainures (251) pour la réalisation d'un polissage chimico-mécanique d'un coeur conducteur de façon sélective par rapport à une couche barrière dans un processus damascène pendant la fabrication d'un circuit intégré, la combinaison comprenant :
la solution dépourvue d'abrasif (252) comportant de l'eau désionisée contenant ce qui suit : de 0,1% à 2,0% d'acide oxalique, de 0,05% à 0,4% de benzotriazole, de 3% à 15% en poids d'une solution de peroxyde à 30%, et de 50 parties par million (ppm) à 100 ppm de Triton X-100 ; et
le tampon à rainures (251) ;
la combinaison aboutissant à une sélectivité de 300:1 environ du coeur conducteur (230) du circuit intégré à une couche barrière (226) du circuit intégré lorsque le coeur conducteur (230) est en cuivre et que la couche barrière (226) est en nitrure de tantale.
